# EUROPEAN PATENT SPECIFICATION

(11) **EP 0 947 938 B1**
(45) Date of publication and mention of the grant of the patent: **13.09.2006**
(21) Application number: 98830204.8
(22) Date of filing: 02.04.1998
(51) Int. Cl.: G06F 17/50, G06F 11/26

(54) **System for emulating an electronic device**
System zur Emulation einer elektronischen Vorrichtung
Système pour émuler un dispositif électronique

(43) Date of publication of application: 06.10.1999
(73) Proprietor: BULL S.A., 78434 Louveciennes Cedex (FR)
(72) Inventor: Bosisio, Giuseppe, 20099 Sesto San Giovanni, Milano (IT); Zulian, Ferruccio, 20010 Cornaredo, Milano (IT)
(74) Representative: Siniscalco, Fabio

(56) References cited:
- US-A- 5 715 433
- BARROSO L A ET AL: "RPM: A RAPID PROTOTYPING ENGINE FOR MULTIPROCESSOR SYSTEMS" COMPUTER, vol. 28, no. 2, 1 February 1995, pages 26-34, XP000502736
- "FUNCTIONAL VERIFICATION OF A MICROPROCESSOR-BASED SYSTEM WITHOUT MANUFACTURING COMPONENTS" IBM TECHNICAL DISCLOSURE BULLETIN, vol. 37, no. 10, 1 October 1994, page 125/126 XP000475601

## Description

The present invention relates to a system for emulating an electronic device, and in particular a system according to the precharacterizing clause of the first claim.

An electronic device consists of a set of circuits (hardware) designed and constructed to carry out a specific task. The electronic device is generally incorporated in a suitable system in such a way that it can be connected to external elements to receive input signals (data); operations of various types (according to specific requirements) are carried out on the input data in such a way as to obtain output signals (results) which are supplied to the external elements.

An electronic device generally consists of an integrated circuit which is specific to a given application (Application Specific Integrated Circuit, or ASIC). The integrated circuit is suitably constructed (custom), it is made by using a sea of gate circuit in which the connections between the various components are customized only by a final metallizing mask (semi-custom), or by using a Field Programmable Gate Array (or FPGA), which can be customized by activating suitable internal connections; alternatively, the electronic device is made by using suitably connected components with a larger or smaller scale of integration (hard-wired logic). These electronic devices differ from programmed logic systems in which a very large-scale integration component (processor) capable of executing instructions of a suitable program is provided; by varying these instructions, it is then possible to program the processor to execute different tasks at different times.

An electronic device, such as an ASIC intended to form an element of a computer system, is generally designed by describing the electronic device by means of suitable high-level languages (Hardware Design Language, or HDL), capable of automatically generating the circuit structure of the electronic device.

Before the real electronic device is physically made, its operation is tested by using software simulators. At a first level of software simulation, the operation of the electronic device in the isolated (stand-alone) state is checked. For this purpose, suitable software applications (simulators) are used, which enable the operation of the electronic device (described in HDL) to be simulated by applying specific values to the input (irritator) and checking the results at the output, and, if appropriate, the values of internal signals (intermediate results). At a second level of software simulation, the interaction of the electronic device with the external elements connected to it is checked; however, this requires the description in HDL of the external elements also (or only of an interface thereof). In any case, the speed of execution of the software simulator is of the order of 50,000-100,000 times lower than that of the real electronic device. For example, a computer system with an operating speed of 100 MHz is simulated at a frequency of 1-2 kHz, and therefore it is only possible to simulate a very small number of instructions of the computer system and not a whole program.

For this reason, hardware emulators are generally used in order to test the operation of the electronic device in a more thorough way. Hardware emulators are based on the use of a prototype of the electronic device, made for example by using an FPGA. The prototype is physically connected to the external elements of the real system by means of suitable sockets, each provided with a cable for connection to the prototype. In the case of fairly complex electronic devices, however, this solution requires the use of a number of FPGAs suitably connected together. The various FPGAs may be connected by means of suitable programmable switches; this solution is fairly efficient in terms of execution speed (of the order of 10-20 times lower than that of the real electronic device, the operating frequency of the computer system being, for example, 5-10 MHz), but presents practical difficulties due to the limited possibilities of interconnection. Alternatively, use is made of a system of FPGAs in which pre-existing connections are controlled by software through a dedicated workstation; this solution is extremely expensive and considerably reduces the execution speed (of the order of 100-200 times lower than that of the real electronic device, the operating frequency of the computer system being, for example, 0.5-1 MHz). In any case, the making of the prototypes entails a high cost and any modification of them requires very long periods of time; moreover, the execution speed of the computer system is limited by the operating frequency of the prototype and is always considerably lower than the real operating speed.

An example of the hardware emulation approach is described by Barroso L. et al. in "RPM: a rapid prototyping engine for multiprocessor systems"; Computer, vol. 28, no. 2, 1 February 1995, pages 26-34, XP000502736.

It should also be noted that both solutions (software simulation and hardware emulation) require the complete description of the electronic device in HDL for the checking of its operation.

The object of the present invention is to overcome the aforesaid disadvantages. In order to achieve this object, a system is proposed for emulating an electronic device as described in the first claim.

The present invention also proposes a passing unit and a programmable unit for use in this system, and a corresponding method for emulating an electronic device.

Further characteristics and the advantages of the method for emulating an electronic device according to the present invention will be understood from the following description of a preferred embodiment of the invention, provided for guidance and without restriction, with reference to the attached figures, in which:
Fig. 1 is a schematic block diagram of a computer system in which the present invention can be used;
Fig. 2 shows an embodiment of the system for emulating an electronic device according to the present invention;
Fig. 3 shows in detail the buffering structure of the passing unit;
Fig. 4 is a schematic block diagram of a method used to control the dialogue with the passing unit;
Figs. 5a-5b show in timing diagrams two examples of transactions executed by the emulation system.

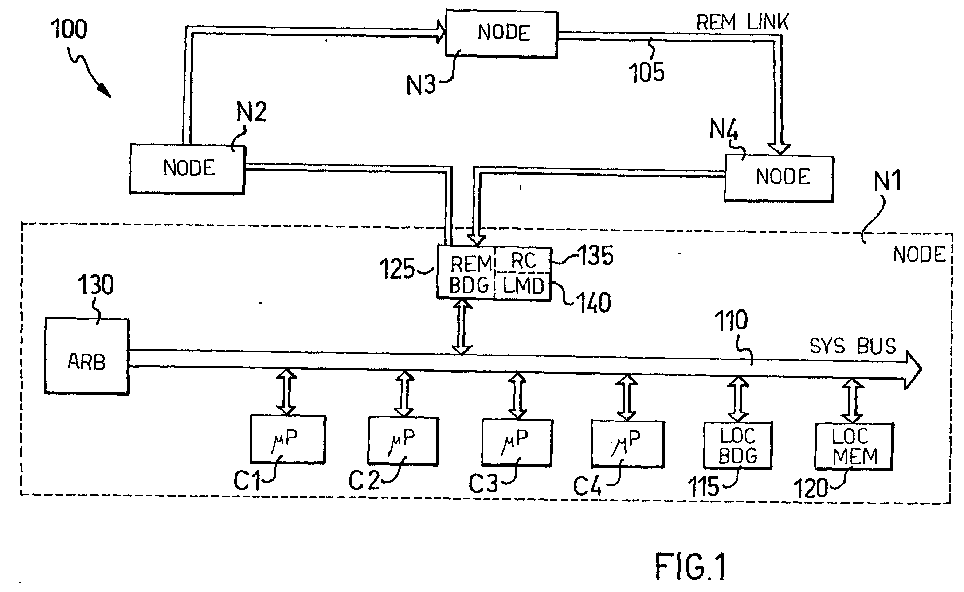

With reference to Fig. 1 in particular, a computer system 100 of the cache coherent - non-uniform memory access, or cc-NUMA, type is shown. The computer system 100 includes two or more nodes N1, N2, N3 and N4 (four in the example shown) interconnected by means of a remote communication channel in the form of a loop 105 (REM LINK).

The node N1 (similar considerations are applicable to the other nodes N2-N4) consists of a system bus 110 (SYS BUS) comprising different portions, one being used for the transmission of addresses (the address bus), one for the transmission of data (the data bus) and one for the transmission of commands (control bus). One or more processors (µP) C1, C2, C3, C4 (four in the example shown), each typically provided with an internal memory of the cache type (generally with two levels), are connected in parallel to the system bus 110. The system bus 110 is also connected to a local bridge unit 115 (LOC BDG) which controls the interconnection with a local bus (not shown in the figure) to which a group (cluster) of input/output (or I/O) control units is connected. The node N1 includes a local memory 120 (LOC MEM), typical of the dynamic random access (or DRAM) type, connected to the system bus 110 through a suitable control unit (not shown in the figure).

A remote bridge unit (REM BDG) 125 connects the node N1 to the remote loop 105 and controls the interconnection of the node N1 with the other nodes N2-N4 of the computer system 100. In particular, the remote bridge unit 125 controls the various communications protocols of the system bus 110 and of the remote loop 105, their various timings, the translation of the addresses used on the system bus 110 and on the remote loop 105, and similar.

The agents C1-C4, 115, 120 and 125 are connected simultaneously (in what is known as the slave mode) to the system bus 110 so that they receive the value transmitted on it; mutually exclusive access (in what is known as the master mode) to the system bus 110 by these agents for sending a given value is controlled by a suitable arbitration unit (ARB) 130. In particular, the arbitration unit 130 is connected to the agents C1-C4, 115, 120 and 125 through dedicated lines (of the control bus) for the exchange of control signals which are used to control the access requests, the granting of access and if necessary the occupation (if this does not have a fixed duration) of the various portions (address and data) of the system 110.

In the computer system 100 described above, each processor C1-C4 can access both data contained in the local memory 120 and data contained in the local memories of the other nodes N2-N4, indicated as a whole by the term "remote memory". Clearly, the access time is not uniform (hence the name NUMA), the remote memory access time being much longer than the local memory access time. To reduce the remote memory access time, the remote bridge unit 125 generally includes a cache memory 135, called the remote cache (RC), in which corresponding data of the remote memory are replicated.

Since the data in both the local memory and the remote memory can be replicated in the various cache memories (internal caches in the processors or remote cache), it is necessary to ensure their coherence (hence the name "cc"). In the node N1, this is typically achieved by means of a snooping process, in which the agents connected to the system bus 110 continuously monitor the coherent data reading/writing requests sent on it, to check whether these data are present in their internal caches.

The coherence of the data in the local memory 120 replicated in the cache memories of the other nodes N2-N4 is controlled by the remote bridge unit 125. To reduce the number of accesses to the other nodes N2-N4, the remote bridge unit 125 generally includes a memory 140 which contains a local memory directory (LMD) which specifies, for each data block (cache line) of the local memory, whether or not this is replicated in other nodes, in which node such a copy is located, and whether or not the copy has been modified.

Each complete logical operation executed on the system bus 110 by the agents C1-C4, 115, 120 and 125 is generally described as a transaction. In particular, a value (ADR), comprising 64 bits for example, indicating an address (comprising 40 bits for example) of a data block (in the local memory, in an internal register of an agent, in the remote memory, or similar) and of attributes relating to this address, is transmitted on the system bus 100. For example, a portion of the value ADR indicates the type of operation required (reading, writing, reading with the intention of modifying the data element, or similar); typically, the data blocks are not controlled in an ordered flow and may be supplied to a requesting processor in an order other than that in which they were requested (out of order), and therefore the value ADR also includes a tag (DTag) which identifies the requesting processor and the transaction relating to it. The transmission of a data block (read or to be written), comprising 512 bits for example, is generally carried out by serializing the operation into a number of successive phases in the course of each of which a portion of the data block, comprising 64 bits for example, and the associated identifying tag DTag are transmitted. On the other hand, packets of information (addresses, data, commands), each comprising 768 bits for example, are transmitted on the remote loop 105.

Each transaction sent on the system bus 110 causes the generation (at specified successive instants) of suitable control signals. In particular, the agents C1-C4, 115, 120 and 125 are connected through dedicated channels (of the control bus) to the arbitration unit 130 for sending a transaction state signal (AStatOut); the arbitration unit 130 is connected to all the agents through a multi-point channel (of the control bus) for sending a collective transaction state signal (AStatIn), which is a function of the value of the various AStatOut signals. Similarly, the agents C1-C4, 115, 120 and 125 are connected through dedicated channels (of the control bus) to the arbitration unit 130 for sending a snooping result signal (ARespOut); the arbitration unit 130 is connected through a multi-point channel (of the control bus) to all the agents for sending a collective snooping result signal (ARespIn), which is a function of the value of the various ARespOut signals.

The present invention is, however, also suitable for application to different computer systems, for example, those with a communication channel between nodes consisting of two or more loops, a network (mesh router), a bus, or other equivalent means of communication, with a different number of nodes, a different number of processors for each node, with the I/O units connected directly to the system bus, or with the arbitration unit provided in the remote bridge unit; alternatively, it is possible to use a computer system with symmetrical processors, a computer system with a single processor, an industrial control system, a numerically controlled machine, or similar. More generally, the present invention can be used to emulate any electronic device connected to external elements for receiving input data, producing corresponding results and supplying the results at the output to the external elements.

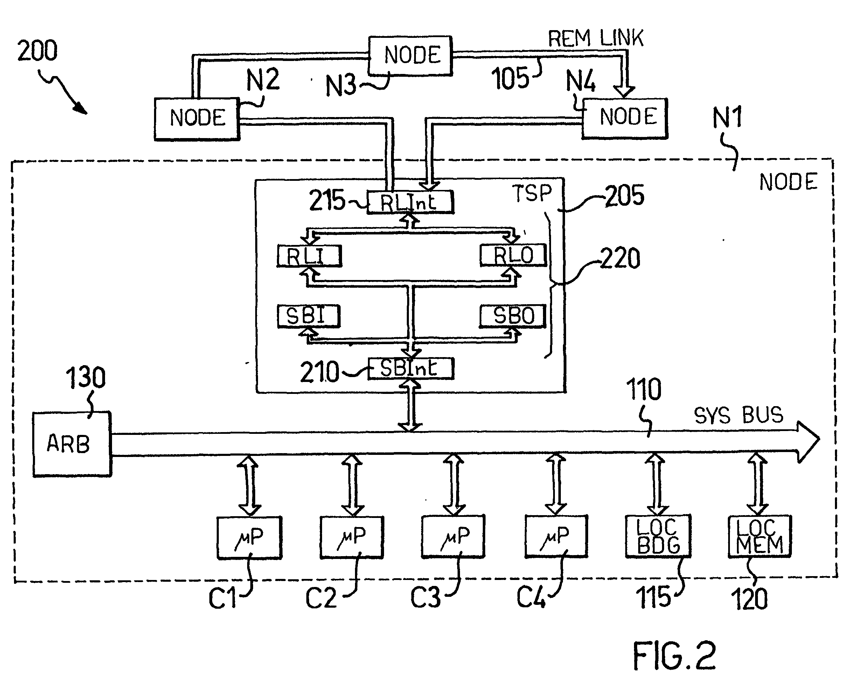

With reference now to Fig. 2 (the elements previously shown in Fig. 1 are identified by the same reference numbers or symbols), a system 200 for emulating the remote bridge unit (indicated by 125 in Fig. 1) of the previously described computer system is shown; similar considerations are applicable in the case of emulation of a different component of the computer system, such as the local memory control unit, the arbitration unit, a processor, or similar.

The remote bridge unit is replaced by a passing unit (transponder, or TSP) 205, connected in a similar way to the remote loop 105 and to the system bus 110. In particular, the passing unit 205 includes an interface unit (SBInt) 210 for receiving and sending values on the system bus 110 and an interface unit (RLInt) 215 for receiving and sending values on the remote loop 105. Preferably the interfaces 210, 215 also directly control the recognition (and possibly the correction) of errors in the value received, and similar.

The passing unit 205 also includes a buffering structure 220 used to store the values received from the system bus 110 and from the remote loop 105 and the values to be sent on them. In particular, an input buffer for the system bus SBI and an output buffer for the system bus SBO are used, respectively, to write the received values and to read the values to be sent on the system bus 110; similarly, an input buffer for the remote loop RLI and an output buffer for the remote loop RLO are used, respectively, to write the received values and to read the values to be sent on the remote loop 105. The interface 210 is connected to the buffers SBI, RLI and SBO, RLO to read the values received from the system bus 110 and from the remote loop 105 and to write the values to be sent on the system bus 110 and on the remote loop 105.

The buffering structure 220 consists of a single memory unit suitably subdivided logically; alternatively, two or more units, a plurality of registers, or equivalent memory means are provided for storing the data and the results. The passing unit 205 includes two separate interfaces 210 and 215; alternatively, a single interface, two three or more separate interfaces, or equivalent interface means are provided to receive the data at the input from the external elements and to write them to the memory means and to read the results from the memory means and to supply them at the output to the external elements.

An emulation processor, for example the processor C1, reads through the interface 210 (as described in detail below) the values stored in the buffering structure 220, or only some of them. The emulation processor C1 executes, by means of a suitable program, the operations which would have to be carried out by the remote bridge unit. For this purpose, the data in the remote cache and in the local memory directory of the remote bridge unit (indicated by 135 and 140 respectively in Fig. 1) are stored in an area of the local memory 120 dedicated to the emulation processor C1. The results obtained from the emulation processor C1 are then written through the interface 210 (as described in detail below) into the buffering structure 220, to be sent subsequently by the interface 210 and by the interface 215 on the system bus 110 and on the remote loop 105 respectively. Preferably, the emulation processor C1 is dedicated to the emulation of the remote bridge unit, in order to ensure a higher execution speed.

This structure has the advantage of permitting the use of a pre-existing component (the processor C1) for emulating the behaviour of the electronic device, without requiring additional elements; moreover, the dialogue between the passing unit 205 and the emulation processor C1 is controlled through the system bus 110, using pre-existing functionality. Alternatively, the processor C1 may also carry out other tasks in concurrent mode, or use may be made of an external processor or personal computer (PC) connected to the passing unit through an additional interface, or in general of any programmable unit connected to the passing unit to obtain the data from the memory means, to determine the corresponding results and to write the results to the memory means.

In the system described above, the electronic device to be emulated is replaced by a passing unit which keeps only its interfaces (with the addition of some buffers for storing the data and the results), while the data processing is executed by a different programmable unit. The passing unit has only the function of receiving the data and passing them on to the programmable unit and the function of receiving the corresponding results from the programmable unit and passing them on to the destination external elements.

The emulation system according to the present invention enables the electronic device to be checked directly in the real system; at the same time, the programmable unit makes the emulation system extremely flexible, with the possibility of making modifications very rapidly. This solution therefore facilitates the testing of the functions of the electronic device and considerably simplifies the process of error tracing (debugging).

The passing unit may be derived directly from similar pre-existing electronic devices. The passing unit and the programmable unit (particularly the program executed by the latter) may also be re-used for checking various similar electronic devices, making this system extremely economical.

The solution according to the present invention enables the logical operation of the electronic device (functional characteristics) and the correctness of its construction (described in HDL) to be checked independently.

This solution makes it possible to check the functional characteristics of the electronic device before or during the phase of construction of the said electronic device, in other words before or during its description in HDL. Thus the checking of the logical correctness of the electronic device is carried out in advance, which is particularly advantageous in the case of highly complex electronic devices. This also makes it possible to add (fully checked) circuit elements to the passing unit in a gradual way during the phases of development of the electronic device.

The passing unit has a very simple structure, so that it can be made, for example, from a single FPGA, and is consequently extremely fast. The passing unit can therefore operate at a speed close to that of the real system. Clearly, the individual operations executed by the programmable unit will be slower. However, since in many applications the operations to be executed by the electronic device form only a small percentage (of the order of 5%) of the total number of operations of the whole system, this solution makes it possible to obtain a total system speed which is even higher than that of known hardware emulation systems (with a plurality of interconnected FPGAs).

It is thus possible to check the operation of the whole system at a speed close to the real speed (for example, approximately 2-5 times slower than the real speed, with an operating frequency of 20-50 MHz). This enables the complete system to be tested in its real operation, with its actual dynamic problems taken into account; for example, in the case of a computer system, it is possible to execute a complete program at a speed close to the real speed, thus obtaining a more complete coverage of the checking process while also testing limit operating conditions and rare events.

This structure enables the system to be modified in advance to adapt it to the new electronic device, for example in order to optimize its performance (tuning); thus the operating environment of the new electronic device can be prepared in parallel with the construction of the device, without the need to wait for the actual availability of the electronic device.

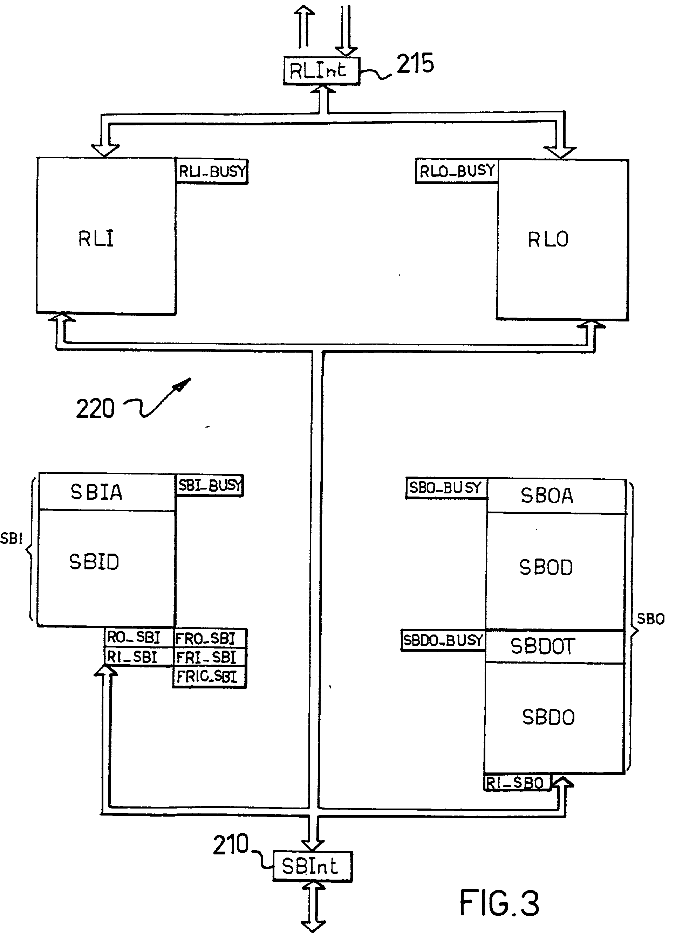

With reference now to Fig. 3 (the elements previously shown in Fig. 2 are identified by the same reference numbers or symbols), the buffering structure of the passing unit is shown in greater detail.

The buffer SBI, used when the passing unit operates in slave mode, includes a system bus input address buffer (SBIA) used to store the address of a data block and the corresponding attributes (type of operation required, associated identification tag, and so on) received from the system address bus; similarly, a system bus input data buffer (SBID) is used to store a data block received from the system data bus. The buffers SBIA and SBID are associated with a corresponding indicator register (flag) SBI_Busy, indicating the state of these buffers.

The buffer SBI is also associated with a register RO_SBI used to store the ARespOut signal indicating the result of the snooping for the transaction stored in the buffer SBI (to be sent to the arbitration unit); the register RO_SBI is associated with a corresponding flag FRO_SBI indicating the state of this register. Similarly, a register RI_SBI is used to store the collective snooping result signal ARespIn for the transaction stored in the buffer SBI (received from the arbitration unit); the register RI_SBI is associated with a corresponding flag FRI_SBI indicating the state of this register. A further flag FRIC_SBI is used to indicate that the transaction stored in the buffer SBI is to be deleted.

The buffer SBO, used when the passing unit operates in master mode, includes a system bus output address buffer (SBOA) used, in a reading or writing transaction, to store the address of a data block and the corresponding attributes to be sent on the system address bus; a system bus output data buffer (SBOD) is used to store the corresponding data block (to be written). The buffers SBOA and SBOD are associated with a corresponding flag SBO_Busy indicating the state of these buffers.

The buffer SBO also includes a system bus output data only tag buffer (SBDOT), used to store the identification tag (to be sent on the system address bus) associated with a data block in an intervention transaction, in which the data block requested by a processor is supplied by an intervening processor (of another node) which has this data block in modified form in its own cache memory; similarly, a system bus output data only buffer (SBDO) is used to store this data block (to be sent on the system data bus). The buffers SBDOT and SBDO are associated with a corresponding flag SBDO_Busy indicating the state of these buffers.

The buffer SBO is also associated with a register RI_SBO used to store the signal ARespIn indicating the collective result of the snooping for the transaction stored in the buffer SBOA (received from the arbitration unit).

The remote loop input buffer RLI is used when the passing unit operates in slave mode, to store a packet received from the remote loop; the buffer RLI is associated with a corresponding flag RLI_Busy indicating the state of this buffer. Similarly, the remote loop output buffer RLO is used when the passing unit operates in master mode, to store a packet to be sent on the remote loop; the buffer RLO is associated with a corresponding flag RLO_Busy indicating the state of this buffer.

If Figs. 2 and 3 are now considered together, the interface 215 receives all the transactions transmitted on the remote loop 105; when a transaction is addressed to the node N1, the interface 215 stores the corresponding packet in the buffer RLI (if this is not busy); when the packet is fully available in the buffer RLI, the interface 215 automatically sets the flag RLI_Busy. This flag is automatically reset by the interface 215 as soon as the emulation processor C1 has fully read the content of the buffer RLI.

Similarly, the interface 210 receives all the transactions transmitted on the system bus 110. The interface 210 checks (by means of the value of the identification tag DTag) the processor which has emitted the transaction. If the requesting processor is different from the emulation processor C1, the transaction is stored in the buffer SBI (if this is not busy); simultaneously, the interface 215 automatically sets the flag SBI Busy and sends to, the arbitration unit 130 a transaction state signal AStatOut indicating that the transaction must be repeated by the requesting processor (AStatOut=Retry). Until the flag SBI_Busy is set, the pasing unit is busy, and therefore other transactions will be deleted and repeated (retried).

The transactions emitted by the processor C1 and not addressed to the passing unit 205 are disregarded, because they are checked directly by the emulation processor C1. When the transaction emitted by the processor C1 is addressed to the passing unit 205, the interface 210 executes the requested operations, consisting (as described in detail below) in the reading or writing of the buffering structure 220.

When the emulation processor C1 discovers (from the content of the flag SBI_Busy) that a new transaction has been stored in the buffer SBI, it executes all the requested operations and determines the value of the corresponding snooping result signal ARespOut. At this point, the emulation processor C1 stores this value in the register RO_SBI; simultaneously, the corresponding flag FRO_SBI is automatically set (the flags FRI_SBI and FRIC_SBI are reset at the same time).

The interface 210 compares all the transactions received from the system bus 110 with the transaction stored in the buffer SBI (address and identification tag). If the received transaction coincides with that stored in the buffer SBI and the flag FRO_SBI is set, the interface 210 sends to the arbitration unit 130 a transaction state signal AStatOut indicating that the transaction can be checked (AStatOut=Null) and, subsequently, the signal ARespOut indicating the result of the snooping stored in the register RO_SBI. Simultaneously, the interface 210 resets the flags SBI_Busy and FRO_SBI so that a new transaction can be stored in the buffer SBI. The interface 210 then receives from the arbitration unit 130 the corresponding collective snooping results signal ARespIn for the preceding transaction, and stores it in the register RI_SBI, simultaneously setting the corresponding flag FRI_SBI, in such a way that this signal is available to be read subsequently by the emulation processor C1; it should be noted that these operations are necessary because this signal ARespIn, which is also received by the emulation processor C1, is disregarded by this processor because it does not correspond to a transaction emitted by it.

In a preferred embodiment of the present invention, the transaction stored in the buffer SBI is deleted after a maximum time interval (time-out). A particularly simple solution consists in the setting (by the interface 210) of the flag FRIC_SBI after a predetermined number (for example 32) of transactions received from the system bus 110 which do not coincide with that stored in the buffer SBI; alternatively, the flag FRIC_SBI may be set after a predetermined number of clock signals used to synchronize the operation of the computer system, for example 96, or similar. This causes the automatic resetting of the flag SBI_Busy and consequently the deletion of the transaction stored in the buffer SBI. In this way it is possible to avoid the phenomena of deadlock of the emulation system 200 caused by deleted transactions which are not re-emitted subsequently.

When the passing unit 205 has to send a transaction on the remote loop 105, the emulation processor C1 stores the packet to be transmitted in the register RLO; when the packet is fully available in the buffer RLO, the interface 215 automatically sets the flag RLO_Busy. The interface 215 then autonomously controls the transmission of this packet on the remote loop 105; as soon as the whole content of the buffer RLO has been sent on the remote loop 105, the interface 215 automatically resets the flag RLO_Busy.

Similarly, when the passing unit 205 has to send a transaction on the system bus 110, the emulation processor C1 stores the corresponding information in the buffer SBO.

In particular, in the case of a reading transaction, the emulation processor C1 stores in the register SBOA the address of the data block to be read, with the corresponding attributes, and, in the case of a writing transaction, the emulation processor C1 stores in the register SBOA the address of the data block to be written, with the corresponding attributes, and stores the corresponding data block in the register SBOD. When this information is fully available in the buffer SBO, the interface 210 automatically sets the flag SBO_Busy.

The interface 215 then automatically controls the access to the system bus 110. The collective snooping result signal ARespIn corresponding to this transaction, generated by the arbitration unit 130, is stored in the register RI_SBO, in such a way that it can be read subsequently by the emulation processor C1.

The flag SBO_Busy is reset automatically by the interface 210 at the end of the transaction. In particular, in the case of a transaction which does not comprise the reading or writing of data, the SBO_Busy is reset as soon as the passing unit 205 has received the corresponding signal ARespIn and has stored it in the register RI_SBO. In other cases, the passing unit 205 receives the corresponding signal ARespIn and stores it in the register RI_SBO. If this signal has a value which indicates that the transaction must be repeated (ARespIn=Retry) or deleted (ARespIn=ReRun), the interface 210 immediately resets the flag SBO_Busy; conversely, the flag SBO_Busy is reset when the data block has been fully received by the system bus 110 in the case of a reading transaction or when it has been fully sent on the system bus 110 in the case of a writing transaction.

In the case of an intervention transaction, however, the emulation processor C1 stores the identification tag of the requested data block in the register SBDOT and stores the data block sent by the intervening processor in the register SBDO. When this information is fully available in the buffer SBO, the interface 210 automatically sets the flag SBDO_Busy. The interface 210 then autonomously controls the transmission of this data block on the system bus 110; as soon as the content of the buffer SBDO has been fully sent on the system bus 110, the interface 210 automatically resets the flag SBDO_Busy.

Similar considerations are applicable in cases in which different values are stored in the buffering structure, other communications protocols are used, buffer queues are provided for the control of a plurality of values of the same type, and others; in general, the results produced by the electronic device to be emulated include state signals for operations associated with corresponding data, and the passing unit generates a state signal indicating that the said operations have not been executed when the corresponding data have been written to the memory means.

Thus, while a transaction is executed by the emulation processor, the system resources do not remain busy while its completion is awaited; this enables the operation of the system to be separated from the actual speed of execution of the transaction by the emulation processor. The present invention is therefore also suitable for application when the system resources are kept busy for the whole transaction executed by the emulation processor, in electronic devices in which state signals are not provided, and similar.

If the emulation processor C1 is now considered, in a preferred embodiment of the present invention this processor periodically interrogates the passing unit 205, by a process known as polling, to check whether the content of the buffering structure 220 has to be read (because it contains new values received from the system bus 110 or from the remote loop 105); similarly, the emulation processor C1 periodically interrogates the passing unit 205 to check whether the buffering structure 220 is free to receive new values.

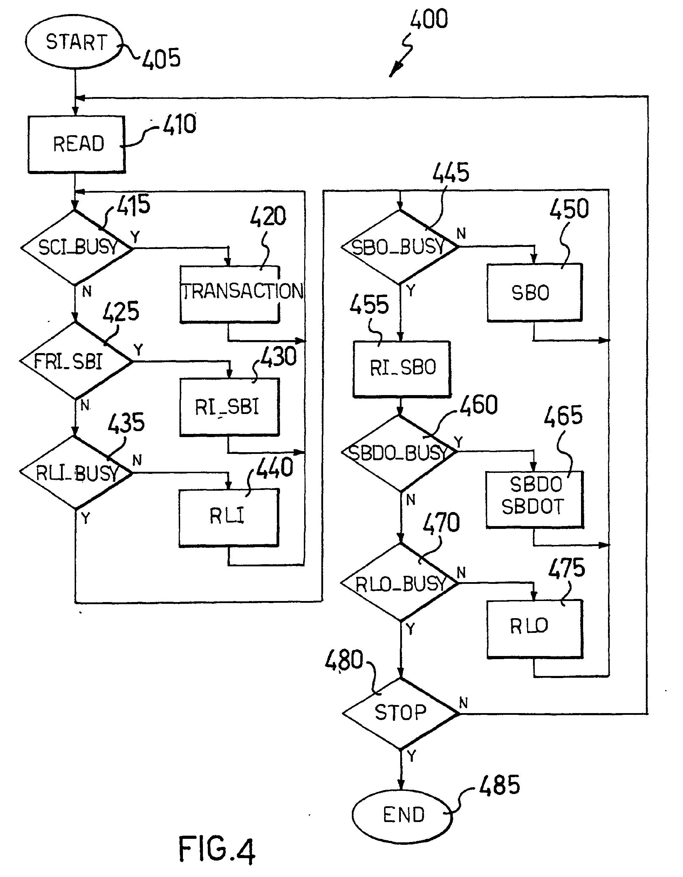

With reference to Fig. 4 in particular, there is shown a schematic block diagram of a method 400 used to control the dialogue with the passing unit according to what has been stated above; this method 400 is implemented by means of a suitable monitor program, implemented in software or firmware and executed by the emulation processor. The method 400 starts at the block 405 and then moves to the block 410 in which the emulation processor reads (by means of a suitable transaction sent on the system bus) the content of the buffering structure of the passing unit.

Moving on to the block 415, the emulation processor checks the content of the flag SBI_Busy. If this flag is set and the content of the buffer SBI has not yet been read, the method proceeds to the block 420, in which the operations associated with the transaction stored in the buffer SBI are executed; in general, once these operations have been started, the method returns directly to the block 415, without waiting for their completion, to resume the monitoring of the input flag of the buffering structure of the passing unit.

In the contrary case, the method continues to the block 425, in which the emulation processor checks the content of the flag FRI_SBI. If this flag is set and the content of the register RI_SBI has not yet been read, the method proceeds to the block 430, in which the collective snooping result signal ARespIn for the transaction in progress is read from the , register RI_SBI, and then returns to the block 415.

In the contrary case, the method proceeds to the block 435, in which the content of the flag RLI_Busy is checked. If this flag is set and the content of the buffer RLI has not yet been read, the method continues to the block 440, in which the content of the packet read from the buffer RLI is interpreted and the associated operations are started (without waiting for their completion); the method then returns to the block 415. In the contrary case, the method moves directly to the block 445 (described below).

Thus the operations in slave mode associated with all the input buffers are executed, with the priority determined by the order in which the corresponding flags are monitored. Only when all the input buffers have been read does the method go on to execute the operations in master mode associated with the output buffers of the buffering structure of the passing unit. This has the advantage of enabling the execution of new transactions to be given priority over the completion of transactions already in progress.

If the block 445 is now considered, the method checks the content of the flag SBO_Busy. If this flag is not set and the emulation processor has to send information (in a reading or writing transaction) on the system bus, the method proceeds to the block 450, in which this information is written (by a suitable transaction) to the buffers SBOA and SBOD; the method then returns to the block 445 to repeat the monitoring of the output flag.

In the contrary case, the method continues to the block 455, in which the emulation processor reads the content of the register RI_SBO, if the collective snooping result signal ARespIn is awaited for a transaction (stored in the buffer SBOA) sent on the system bus by the passing unit.

With reference now to the block 460, the emulation processor checks the content of the flag SBDO_Busy. If this flag is not set and the emulation processor has to send information (in an intervention transaction) on the system bus, the method proceeds to the block 465, in which this information is written (by means of a suitable transaction) to the buffers SBDOT and SBDO, and then returns to the block 445.

In the contrary case, the method proceeds to the block 470, in which the emulation processor checks the content of the flag RLO_Busy. If this flag is not set and the emulation processor has to send a packet on the remote loop, this packet is written (by means of a suitable transaction) to the buffer RLO; the method then returns to the block 445.

In the contrary case, the method checks in block 480 whether the interruption of the monitoring program being executed in the emulation processor has been requested. If this is so, the method terminates at the end block 485, while if this is not so the method returns to the block 410 so that the operations described above can be repeated continuously.

Alternatively, the various flags may be monitored with different priorities (for example, according to estimated scheduling policies), the various buffers, flags and registers read from the passing unit may be controlled by means of corresponding concurrent processes, the emulation processor may send the values to be written to the buffering structure to the passing unit in every case (receiving a state signal for the transaction AStatOut=Retry if the corresponding buffer is not free), the passing unit may send an interrupt signal to the emulation processor when the content of the buffering structure has been modified by the interfaces with the system bus and with the remote loop (this signal being masked until its serving has been completed), or different interrupt signals may be used to indicate certain situations to be treated as having high priority, such as the setting of the flag SBI_Busy, the flag RLI_Busy and the flag SBO_Busy, the passing unit may send the data directly to the emulation processor, or similar.

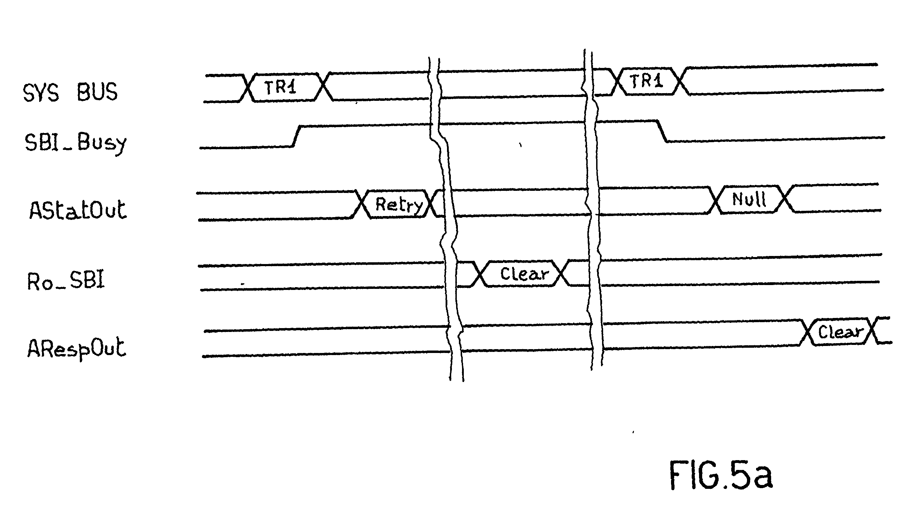

An example of a transaction executed by the emulation system described above is shown in the timing diagram in Fig. 5a. As usual, one signal (one bit) is represented by a single line, while values comprising a plurality of bits are represented by a band (the crossing points are the instants of switching).

It is assumed that a generic processor (for example the processor indicated by C3 in Fig. 3) sends a transaction TR1 on the system bus (SYS BUS) to request the reading of a data block in the local memory. The transaction TR1 is received from the corresponding interface and stored in the buffer SBI (the flag SBI_Busy being set automatically). The interface with the system bus then sends to the arbitration unit a transaction state signal AStatOut=Retry so that the transaction TR1 is deleted.

The emulation processor then reads the content of the buffer SBI and then checks the transaction TR1 stored in it. It is assumed that the emulation processor C1 discovers (by examining the content of the directory stored in the local memory) that the requested data element is not present in modified form in any of the other nodes of the system. In this case, the emulation processor writes the AStatOut value of the corresponding snooping result (AStatOut=Clean) to the RO_SBI register (the flag FRO_SBI being set automatically).

When the requesting processor C3 again sends the transaction TR1 on the system bus, this transaction is received by the corresponding interface, which checks that it coincides with the transaction stored in the buffer SBI (and that the flag FRO_SBI is set). At this point, the interface with the system bus sends to the arbitration unit a transaction state signal AStatOut=Null and then the ARespOut signal of the result of the snooping stored in the register RO_SBI (ARespOut=Clean), while the flags SBI_Busy and FRO_SBI are reset automatically.

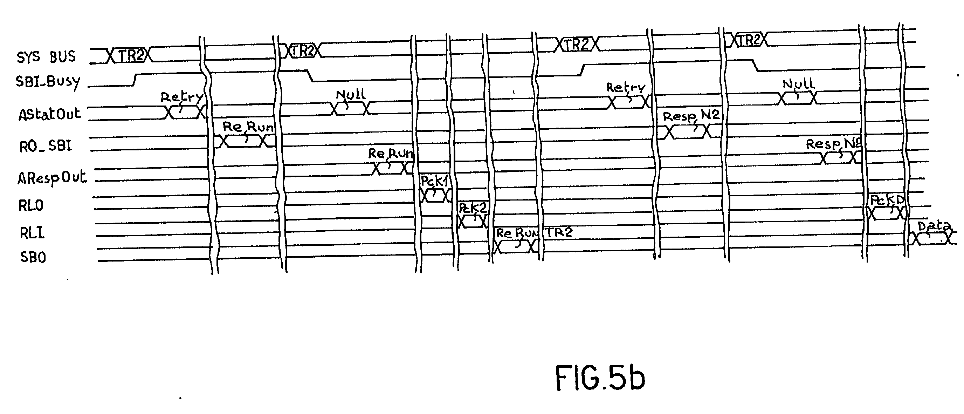

With reference now to Fig. 5b, the processor C3 sends a further transaction TR2 on the system bus to request the reading of a data block in the local memory, which is stored in the buffer SBI and subsequently read by the emulation processor in the same way as in the preceding case.

Let us now assume that the emulation processor finds (by examining the content of the directory stored in the local memory) that the request data element is present in modified form in another node (for example the node indicated by N2 in Fig. 2). In this case, the emulation processor writes to the register RO_SBI a value AStatOut of the result of the snooping indicating that the transaction must be deleted and suspended for subsequent reactivation (ARespOut=ReRun), the flag FRO_SBI being set automatically.

When the requesting processor C3 again sends the transaction TR2 on the system bus, this transaction is received by the corresponding interface, which checks that it coincides with the transaction stored in the buffer SBI (and that the flag FRO_SBI is set). At this point, the interface with the system bus sends to the arbitration a transaction state signal AStatOut=Null and subsequently the ARespOut signal of the result of the snooping stored in the register RO_SBI (ARespOut=ReRun), while the flags SBI_Busy and FRO_SBI are reset automatically.

At the same time, the emulation processor writes to the buffer RLO a packet PCK1 corresponding to the transaction TR2 (the flag RLO_Busy being set automatically), which is then sent to the node N2 (the flag RLO_Busy being reset automatically). The node N2 then sends to the passing unit a response packet PCK2 for this transaction, which is received by the interface with the remote loop and is stored in the buffer RLI (the flag RLI_Busy being set automatically).

The emulation processor then reads the content of the buffer RLI (the flag RLI_Busy being reset automatically), and obtains from the packet PCK2 the value ARespOut of the result of the snooping of the transaction TR2 (ARespOut=RespN2).

The emulation processor writes to the buffer SBO (the flag SBO_Busy being set automatically) a transaction to reactivate the transaction TR2 which was previously suspended (ReRun TR2), which is then sent on the system bus (while the flag SBO_Busy is automatically reset). When the requesting processor C3 sends the transaction TR2 again on the system bus, this transaction is received as before by the corresponding interface and stored in the buffer SBI, while the flag SBI_Busy is automatically set (by the sending of a transaction state signal AStatOut=Retry to the arbitration unit). The emulation processor then reads the content of the buffer SBI and, since it already has access to the corresponding snooping result signal (received previously from the node N2), writes this value ARespOut=RespN2 to the register RO_SBI, while the flag FRO_SBI is automatically set.

When the requesting processor C3 again sends the transaction TR2 on the system bus, this transaction is received by the corresponding interface, which checks that it coincides with the transaction stored in the buffer SBI (and that the flag FRO_SBI is set). At this point, the interface with the system bus sends to the arbitration unit a transaction state signal AStatOut=Null and then the signal ARespOut of the result of the snooping stored in the register RO_SBI (ARespOut=RespN2), while the flags SBI_Busy and FRO_SBI are automatically reset.

The node N2 (if it has not deleted the transaction TR2) then sends to the remote loop a packet PCKD containing the requested data block, which is received by the corresponding interface and is stored in the buffer RLI (the flag RLI_Busy being set automatically).

The emulation processor then reads the content of the buffer RLI (the flag RLI_Busy being reset automatically) and obtains from the packet PCKD the requested data block (Data). The emulation processor writes to the buffer SBO (while the flag SBDO_Busy is automatically set) the requested data block (with the identification tag associated with the transaction TR2), which is then sent on the system bus to the requesting processor C3 (while the flag SBDO_Busy is automatically reset).

Similar considerations are applicable to other types of transaction, such as a request for reading a data block from the remote memory, a request for writing a data block to the local memory, a request for writing a data block to the remote memory, and similar.

Clearly, a person skilled in the art may make numerous modifications and changes to the system for emulating an electronic device described above, to meet contingent and specific requirements, all these modifications and changes being contained within the scope of protection of the invention as defined in the following claims.

## Claims

1. System (200) for emulating an electronic device (125) connectable to external elements (C1-C4, 115, 120, 130) for receiving input data, determining corresponding results and supplying the results at the output to the external elements (C1-C4, 115, 120, 130),
**characterized in that**
it includes a passing unit (205) having memory means (220) for storing the data and the results, interface means (210) for receiving the data at the input from the external elements (C1-C4, 115, 120, 130) and writing them to the memory means (220) and for reading the results from the memory means (220) and supplying them at the output to the external elements (C1-C4, 115, 120, 130), and
a programmable unit (C1) for emulating the behaviour of the electronic device connected to the passing unit (205) for obtaining the data from the memory means (220), for determining the corresponding results and for writing the results to the memory means (220).

2. System (200) for emulating an electronic device (125) according to Claim 1, in which the results include state signals for operations associated with the data, the passing unit (205) generating a state signal indicating that the said operations have not been executed when the corresponding data have been written to the memory means (220).

3. System (200) for emulating an electronic device (125) according to Claim 2, in which the passing unit (205) deletes the said operations if the corresponding data have not been received again by the passing unit (205) within a specified time interval.

4. System (200) for emulating an electronic device (125) according to any of Claims 1 to 3, in which the electronic device (125) is an element of a computer system (100) comprising at least one processor (C1-C4), the programmable unit being included in an emulation processor (C1).

5. System (200) for emulating an electronic device (125) according to Claim 4, in which the emulation processor (C1) is a dedicated processor.

6. System (200) for emulating an electronic device (205) according to Claim 4 or 5, comprising a communication bus (110) to which the passing unit (205) and the at least one processor (C1-C4) are connected, the emulation processor (C1) obtaining the data from the memory means (220) and writing the results to the memory means (220) through the communication bus (110).

7. System (200) for emulating an electronic device (125) according to any of Claims 4 to 6, in which the computer system (100) is of the cc-NUMA type comprising a plurality of nodes (N1-N4) interconnected by a remote communication means (105), and in which the electronic device is a bridge unit (125) for connecting a first node (N1) to the other nodes (N2-N4) of the computer system (100), the emulation processor (C1) and the communication bus (110) being included in the first node (N1).

8. System (200) for emulating an electronic device (125) according to Claim 7, in which each node (N1-N4) includes a local memory (120), the bridge unit (125) comprising a memory of the cache type (135) for storing corresponding data from the local memories of the other nodes (N2-N4) and an additional memory (140) for storing state information relating to data in the local memory (120) of the first node (N1) replicated in the other nodes (N2-N4), the data in the memory of the cache type (135) and in the additional memory (140) being stored in a portion of the local memory (120) of the first node (N1) associated with the emulation processor (C1).

9. System (200) for emulating an electronic device (125) according to Claim 7 or 8, in which the passing unit includes first (210) and second (215) interface means connected, respectively, to the communication bus (110) and to the remote communication means (105).

10. System (200) according to Claim 9, in which the emulation processor (C1) obtains the data from the memory means (220) and writes the results to the memory means (220) through the first interface (210).

11. System (200) according to Claim 10, in which the emulation processor (C1) periodically reads the data from the memory means (220) by a polling process.

12. Passing unit (205) for use in the emulation system (200) according to any of Claims 1 to 11.

13. Programmable unit (C1) for use in the emulation system (200) according to any of Claims 1 to 11.

14. Method for emulating an electronic device (125) connectable to external elements (C1-C4, 115, 120, 130) for receiving input data, determining corresponding results and supplying the results at the output to the external elements (C1-C4, 115, 120, 130),
**characterized by** the steps of
receiving at the input in a passing unit (205) the data from the external elements (C1-C4, 115, 120, 130) through interface means (210) and writing them to memory means (220),
obtaining (410) in a programmable unit (C1) emulating the behaviour of the electronic device and connected to the passing unit (205) the data from the memory means (220),
determining (415-440) the corresponding results through the programmable unit (C1).
writing (445-475) the results determined by the programmable unit (C1) to the memory means (220),
reading the results from the memory means (220) through the interface means (210) and supplying them at the output to the external elements (C1-C4, 115, 120, 130).

## Patentansprüche

1. System (200) zum Emulieren einer elektronischen Vorrichtung (125), die mit externen Elementen (C1 - C4, 115, 120, 130) verbindbar ist, zum Empfangen von Eingangsdaten, zum Bestimmen entsprechender Ergebnisse und zum Liefern der Ergebnisse an dem Ausgang an die externen Elemente (C1 C4, 115, 120, 130),
**dadurch gekennzeichnet, dass**
dasselbe eine Leiteinheit (205) umfasst, die eine Speichereinrichtung (220) zum Speichern der Daten und der Ergebnisse, eine Schnittstelleneinrichtung (210) zum Empfangen der Daten an dem Eingang von den externen Elementen (C1-C4, 115, 120, 130) und zum Schreiben derselben in die Speichereinrichtung (220) und zum Lesen der Ergebnisse von der Speichereinrichtung (220) und zum Liefern derselben an dem Ausgang an die externen Elemente (C1 - C4, 115, 120, 130) aufweist, und
eine programmierbare Einheit (C1) zum Emulieren des Verhaltens der elektronischen Vorrichtung, die mit der Leiteinheit (205) verbunden ist, zum Erhalten der Daten von der Speichereinrichtung (220), zum Bestimmen der entsprechenden Ergebnisse und zum Schreiben der Ergebnisse in die Speichereinrichtung (220).

2. System (200) zum Emulieren einer elektronischen Vorrichtung (125) gemäß Anspruch 1, bei dem die Ergebnisse Zustandssignale für Operationen umfassen, die den Daten zugeordnet sind, wobei die Leiteinheit (205) ein Zustandssignal erzeugt, das anzeigt, dass die Operationen nicht ausgeführt worden sind, wenn die entsprechenden Daten in die Speichereinrichtung (220) geschrieben worden sind.

3. System (200) zum Emulieren einer elektronischen Vorrichtung (125) gemäß Anspruch 2, bei dem die Leiteinheit (205) die Operationen löscht, wenn die entsprechenden Daten nicht innerhalb eines spezifizierten Zeitintervalls erneut durch die Leiteinheit (205) empfangen worden sind.

4. System (200) zum Emulieren einer elektronischen Vorrichtung (125) gemäß einem der Ansprüche 1 bis 3, bei dem die elektronische Vorrichtung (125) ein Element eines Computersystems (100) ist, das zumindest einen Prozessor (C1 - C4) aufweist, wobei die programmierbare Einheit in einem Emulationsprozessor (C1) enthalten ist.

5. System (200) zum Emulieren einer elektronischen Vorrichtung (125) gemäß Anspruch 4, bei dem der Emulationsprozessor (C1) ein eigens vorgesehener Prozessor ist.

6. System (200) zum Emulieren einer elektronischen Vorrichtung (205) gemäß Anspruch 4 oder 5, das einen Kommunikationsbus (110) aufweist, mit dem die Leiteinheit (205) und der zumindest eine P-rozessor (C1 - C4) verbunden sind, wobei der Emulationsprozessor (C1) durch den Kommunikationsbus (110) die Daten von der Speichereinrichtung (220) erhält und die Ergebnisse in die Speichereinrichtung (220) schreibt.

7. System (200) zum Emulieren einer elektronischen Vorrichtung (125) gemäß einem der Ansprüche 4 bis 6, bei dem das Computersystem (100) von dem cc-NUMA-Typ ist, der eine Mehrzahl von Knoten (N1 - N4) aufweist, die durch eine entfernte Kommunikationseinrichtung (105) verbunden sind, und bei dem die elektronische Vorrichtung eine Brückeneinheit (125) zum Verbinden eines ersten Knotens (N1) mit den anderen Knoten (N2 - N4) des Computersystems (100) ist, wobei der Emulationsprozessor (C1) und der Kommunikationsbus (110) in dem ersten Knoten (N1) enthalten sind.

8. System (200) zum Emulieren einer elektronis-chen Vorrichtung (125) gemäß Anspruch 7, bei dem jeder Knoten (N1 - N4) einen lokalen Speicher (120) umfasst, wobei die Brückeneinheit (125) einen Speicher des Cache-Typs (135) zum Speichern entsprechender Daten von den lokalen Speichern der anderen Knoten (N2 - N4) und einen zusätzlichen Speicher (140) zum Speichern von Zustandsinformationen bezüglich Daten in dem lokalen Speicher (120) des ersten Knotens (N1), die in den anderen Knoten (N2 - N4) reproduziert sind, aufweist, wobei die Daten in dem Speicher des Cache-Typs (135) und in dem zusätzlichen Speicher (140) in einem Abschnitt des lokalen Speichers (120) des ersten Knotens (N1) gespeichert sind, der dem Emulationsprozessor (C1) zugeordnet ist.

9. System (200) zum Emulieren einer elektronischen Vorrichtung (125) gemäß Anspruch 7 oder 8, bei dem die Leiteinheit eine erste (210) und eine zweite (215) Schnittstelleneinrichtung umfasst, die mit dem Kommunikationsbus (110) beziehungsweise mit der entfernten Kommunikationseinrichtung (105) verbunden sind.

10. System (200) gemäß Anspruch 9, bei dem der Emulationsprozessor (C1) durch die erste Schnittstelle (210) die Daten von der Speichereinrichtung (220) erhält und die Ergebnisse in die Speichereinrichtung (220) schreibt.

11. System (200) gemäß Anspruch 10, bei dem der Emulationsprozessor (C1) die Daten periodisch durch einen Abrufprozess von der Speichereinrichtung (220) liest.

12. Leiteinheit (205) zur Verwendung bei dem Emulationssystem (200) gemäß einem der Ansprüche 1 bis 11.

13. Programmierbare Einheit (C1) zur Verwendung bei dem Emulationssystem (200) gemäß einem der Ansprüche 1 bis 11.

14. Verfahren zum Emulieren einer elektronischen Vorrichtung (125), die mit externen Elementen (C1 - C4, 115, 120, 130) verbindbar ist,_ zum Empfangen von Eingangsdaten, zum Bestimmen entsprechender Ergebnisse und zum Liefern der Ergebnisse an dem Ausgang an die externen Elemente (C1 - C4, 115, 120, 130),
**gekennzeichnet durch** folgende Schritte:
Empfangen der Daten von den externen Elementen (C1 - C4, 115, 120, 130) **durch** eine Schnittstelleneinrichtung (210) an dem Eingang bei einer Leiteinheit (205) und Schreiben derselben in eine Speichereinrichtung (220),
Erhalten (410) der Daten von der Speichereinrichtung (220) in einer programmierbaren Einheit (C1), die das Verhalten der elektronischen Vorrichtung emuliert und mit der Leiteinheit (205) verbunden ist,
Bestimmen (415 - 440) der entsprechenden Ergebnisse durch die programmierbare Einheit (C1),
Schreiben (445 - 475) der Ergebnisse, die **durch** die programmierbare Einheit (C1) bestimmt werden, in die Speichereinrichtung (220),
Lesen der Ergebnisse von der Speichereinrichtung (220) durch die Schnittstelleneinrichtung (210) und Liefern derselben an dem Ausgang an die externen Elemente (C1 - C4, 115, 120, 130).

## Revendications

1. Système (200) d'émulation d'un dispositif électronique (125) connectable à des éléments extérieurs (C1-C4, 115, 120, 130) afin de recevoir des données d'entrée, de déterminer des résultats correspondants et de délivrer en sortie les résultats aux éléments extérieurs (C1-C4, 115, 120, 130),
**caractérisé en ce que**
il comprend une unité (205) de passage comportant un moyen de mémoire (220) destiné à mémoriser les données et les résultats, un moyen d'interface (210) destiné à recevoir à l'entrée les données délivrées par les éléments extérieurs (C1-C4, 115, 120, 130) et à les écrire dans le moyen de mémoire (220), et à lire les résultats dans le moyen de mémoire (220) et à les délivrer en sortie aux éléments extérieurs (C1-C4, 115, 120, 130), et
une unité programmable (C1) destinée à émuler le comportement du dispositif électronique, connectée à l'unité (205) de passage afin d'obtenir les données du moyen de mémoire (220), afin de déterminer les résultats correspondants et afin d'écrire les résultats dans le moyen de mémoire (220).

2. Système (200) d'émulation d'un dispositif électronique (125) selon la revendication 1, dans lequel les résultats comprennent des signaux d'état pour les opérations associées aux données, l'unité (205) de passage générant un signal d'état indiquant que lesdites opérations n'ont pas été exécutées quand les données correspondantes ont été écrites dans le moyen de mémoire (220).

3. Système (200) d'émulation d'un dispositif électronique (125) selon la revendication 2, dans lequel l'unité (205) de passage efface lesdites opérations si les données correspondantes n'ont pas été reçues à nouveau par l'unité (205) de passage dans un intervalle de temps spécifié.

4. Système (200) d'émulation d'un dispositif électronique (125) selon l'une quelconque des revendications 1 à 3, dans lequel le dispositif électronique (125) est un élément d'un système (100) d'ordinateur comprenant au moins un processeur (C1-C4), l'unité programmable étant incluse dans un processeur (C1) d'émulation.

5. Système (200) d'émulation d'un dispositif électronique (125) selon la revendication 4, dans lequel le processeur (C1) d'émulation est un processeur dédié.

6. Système (200) d'émulation d'un dispositif électronique (125) selon la revendication 4 ou 5, comprenant un bus (110) de communication auquel sont connectés l'unité (205) de passage et l'au moins un processeur (C1-C4), le processeur (C1) d'émulation obtenant les données du moyen de mémoire (220) et écrivant les résultats dans le moyen de mémoire (220) par l'intermédiaire du bus (110) de communication .

7. Système (200) d'émulation d'un dispositif électronique (125) selon l'une quelconque des revendications 4 à 6, dans lequel le système (100) d'ordinateur est du type cc-NUMA comprenant une pluralité de noeuds (N1-N4) interconnectés par un moyen (105) de communication distant, et dans lequel le dispositif électronique est une unité (125) en pont destinée à connecter un premier noeud (N1) aux autres noeuds (N2-N4) du système (100) d'ordinateur, le processeur (C1) d'émulation et le bus (110) de communication étant inclus dans le premier noeud (N1).

8. Système (200) d'émulation d'un dispositif électronique (125) selon la revendication 7, dans lequel chaque noeud (N1-N4) comprend une mémoire locale (120), l'unité (125) en pont comprenant une mémoire (135) de type cache destinée à mémoriser les données correspondantes délivrées par les mémoires locales des autres noeuds (N2-N4) et une mémoire additionnelle (140) destinée à mémoriser les informations d'état se rapportant aux données dans la mémoire locale (120) du premier noeud (N1), reproduites dans les autres noeuds (N2-N4), les données dans la mémoire (135) de type cache et dans la mémoire additionnelle (140) étant mémorisées dans une partie de la mémoire locale (120) du premier noeud (N1) associée au processeur (C1) d'émulation.

9. Système (200) d'émulation d'un dispositif électronique (125) selon la revendication 7 ou 8, dans lequel l'unité de passage comprend des premier (210) et deuxième (215) moyens d'interface connectés respectivement au bus (110) de communication et au moyen (105) de communication distant.

10. Système (200) selon la revendication 9, dans lequel le processeur (C1) d'émulation obtient les données du moyen de mémoire (220) et écrit les résultats dans le moyen de mémoire (220) au moyen de la première interface (210).

11. Système (200) selon la revendication 10, dans lequel le processeur (C1) d'émulation lit périodiquement les données dans le moyen de mémoire (220) par un processus de scrutation.

12. Unité (205) de passage destinée à l'utilisation dans le système (200) d'émulation selon l'une quelconque des revendications 1 à 11.

13. Unité (C1) programmable destinée à l'utilisation dans le système (200) d'émulation selon l'une quelconque des revendications 1 à 11.

14. Procédé d'émulation d'un dispositif électronique (125) connectable à des éléments extérieurs (C1-C4, 115, 120, 130) afin de recevoir des données d'entrée, de déterminer des résultats correspondants et de délivrer en sortie les résultats aux éléments extérieurs (C1-C4, 115, 120, 130),
**caractérisé par** les étapes consistant à
recevoir en entrée dans une unité (205) de passage les données des éléments extérieurs (C1-C4, 115, 120, 130) par l'intermédiaire d'un moyen (210) d'interface et les écrire dans un moyen de mémoire (220),
obtenir (410) dans une unité (C1) programmable émulant le comportement du dispositif électronique, connectée à l'unité- (205) de passage, les données délivrées par le moyen de mémoire (220),
déterminer (415-440) les résultats correspondants au moyen de l'unité programmable (C1),
écrire (445-475) dans le moyen de mémoire (220) les résultats déterminés par l'unité programmable (C1),
lire les résultats dans le moyen de mémoire (220) à l'aide du moyen (210) d'interface et les délivrer en sortie aux éléments extérieurs (C1-C4, 115, 120, 130).
